Europäisches Patentamt

European Patent Office

Office européen des brevets

(11) Numéro de publication: **0 029 785**
**A1**

## (12) DEMANDE DE BREVET EUROPEEN

(21) Numéro de dépôt: 80401671.5

(22) Date de dépôt: 21.11.80

(51) Int. Cl.³: **G 06 K 7/06**
**G 06 K 19/06**

(30) Priorité: 27.11.79 FR 7929115

(43) Date de publication de la demande:
03.06.81 Bulletin 81/22

(84) Etats Contractants Désignés:
BE CH DE GB IT LI NL SE

(71) Demandeur: SOCIETE FLONIC
12, Place des Etats-Unis
F-92541 Montrouge(FR)

(72) Inventeur: Rose, René
15, rue de l'Etang
F-78190 Voisins-1e-Bretonneux(FR)

(74) Mandataire: Havre, Henri
GIERS SCHLUMBERGER 12, Place des Etats-Unis
F-92124 Montrouge(FR)

(54) Système de connexion électrique.

(57) Dans un système de connexion électrique entre une carte de paiement (10) munie d'un circuit intégré à mémoire (11) et un appareil de transfert d'informations (15) pour l'inscription et pour la lecture de données dans la mémoire du circuit, les contacts (14) de la carte (10) sont recouverts d'une couche de protection en matériau plastique perforable et rétractable (13), et l'appareil de transfert est équipé, pour chaque contact, d'une tige en métal dur (16) se terminant par une pointe (17) pour être appliquée avec une force déterminée sur le contact correspondant de la carte à travers la couche de protection.

FIG.1

EP 0 029 785 A1

1

## Système de connexion électrique

La présente invention est relative à un système de connexion électrique entre un objet amovible, porteur d'un circuit électronique, et un appareillage électrique.

Plus précisément, l'invention est applicable à la connexion électrique temporaire d'une carte ou analogue (clé, bague) porteuse d'informations contenues dans une mémoire faisant partie d'un circuit intégré, avec un appareil de transfert permettant la lecture et/ou l'écriture d'informations dans la mémoire de la carte. Une telle carte peut servir de carte d'identification ou d'accès contrôlé, de carte de crédit ou de paiement, et plus généralement de carte à transactions pour la prise en compte d'opérations bancaires ou commerciales, et des exemples sont décrits plus en détail dans les brevets français N° 2 266 222, 2 304 992, 2 304 989, 2 304 965, 2 311 365, 2 311 360. Dans la suite, on utilisera l'expression "carte à mémoire" pour désigner une carte du genre ci-dessus, quelle que soit son utilisation.

Par connexion électrique, on entend l'établissement d'un ou plusieurs contacts électriques entre les bornes du circuit électronique contenu dans la carte à mémoire (contacts palpés) et les contacts de palpage correspondants de l'appareillage électrique (contacts palpeurs) pour réaliser un branchement électrique entre les circuits de ces deux éléments permettant un échange de données.

On sait que les contacts qui doivent présenter une carte à mémoire posent un certain nombre de conditions plus ou moins incompatibles :

a) il convient de préserver les contacts d'un encrassement et d'une usure qui compromettraient un passage correct du courant par création d'une chute de potentiel élevée inacceptable ;

b) il est aussi nécessaire de réduire l'encombrement des surfaces de contact, limitées par la place disponible sur la carte, notamment

2

dans le cas d'une carte de format normalisé ;

c) il est encore souhaitable que l'établissement de la connexion se fasse rapidement dès que la carte parvient à son emplacement de palpage par les contacts de l'appareillage électrique.

L'invention a précisément pour objet un système de connexion dans lequel les difficultés énoncées ci-dessus sont en majeure partie surmontées.

Le système de connexion, suivant l'invention, entre une carte à mémoire ou analogue, amovible, porteuse d'un circuit électronique recouvert extérieurement d'une couche de protection, et un appareillage électrique pour établir une liaison électrique entre au moins une paire de contacts respectivement disposés dans l'appareillage et dans la carte, est caractérisé en ce que :

- d'une part, ladite couche de protection du circuit électronique est constitué au moins à l'aplomb du contact, par un matériau plastique présentant la propriété d'être perforable,

- d'autre part, ledit appareillage comporte au moins une tige en métal dur se terminant par une pointe pouvant être, en fonctionnement, appliquée avec une force déterminée sur le contact de la carte à travers la couche de protection. De préférence, ledit matériau plastique a aussi la propriété d'être rétractable.

Ainsi, l'utilisation d'un matériau de protection plastique pouvant être perforé sous la pression de la pointe de la tige et se refermer après le retrait de celle-ci, si ce matériau est aussi rétractable, assure une protection permanente des contacts de la carte contre les salissures et les attaques des agents atmosphériques auxquels des contacts superficiels seraient normalement soumis. L'utilisation d'un matériau simplement perforable assure une protection moins parfaite que s'il est aussi rétractable, mais néanmoins très avantageuse vis-à-vis de contacts extérieurs sans protection en raison de la finesse de la perforation.

En outre, l'établissement d'un contact quasi-ponctuel sous une force d'application donnée détermine une surface de contacts mutuels bien définie qui, par un choix approprié des métaux en présence, conserve ses dimensions après un nombre élevé d'établissements de contacts temporaires.

Il est aussi remarquable que l'utilisation d'une tige à extrémité pointue comme contact palpeur ne nécessite qu'un encombrement minimal, tant pour la réalisation d'un ensemble de contacts de palpage dans l'appareillage, par exemple sous forme de peigne, que pour les bornes constituant les contacts palpés du circuit porté par la carte à mémoire, dont les dimensions peuvent être du même ordre que celle de l'extrémité pointue des tiges.

De préférence, la pointe à l'extrémité d'une tige palpeuse a un rayon de l'ordre de 5 à 100 microns et est constituée en tungstène, métal se prêtant à l'obtention d'extrémités effilées par voie électrolytique, ou encore en acier ; les contacts palpés de la carte sont choisis en un métal de dureté inférieure à celle du tungstène ou de l'acier, tel que le cuivre, l'argent, l'indium, et tous les métaux ou alliages présentant des caractéristiques électriques satisfaisantes.

D'autres caractéristiques et avantages de l'invention ressortiront de la description suivante et des dessins annexés donnés à titre d'exemples non limitatifs de modes de mise en oeuvre d'un système conforme à l'invention. Sur ce dessin :

  - la fig. 1 montre schématiquement un système de connexion expliquant le principe de l'invention.

  - la fig. 2 représente un premier mode de réalisation d'une carte contenant un circuit électronique apte à être connecté avec un appareillage extérieur suivant le système de la fig. 1.

- les fig. 3 et 4 représentent respectivement en coupe et en vue perspective avec arrachement partiel un autre mode de réalisation de la carte de la fig. 2.

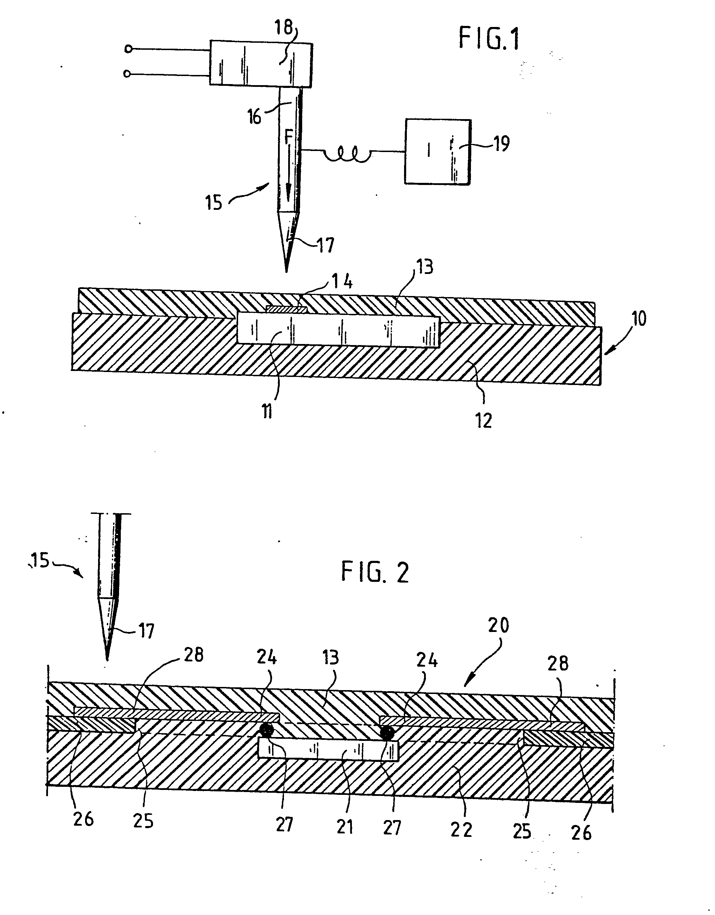

Sur la fig. 1, on voit en 10 un objet, amovible ou portatif, sous forme de carte, représenté en coupe transversale, qui comporte un circuit
électronique 11, par exemple un circuit intégré, monté ou enrobé dans
un support 12 en matériau isolant, par exemple en polyester, et recouvert par une couche de protection 13. Le circuit 11 présente au
moins une borne de contact 14 dont on veut établir la connexion électrique avec un appareillage 15 comportant un contact palpeur 16.

Conformément à l'invention, d'une part le contact 14 du circuit 11
est recouvert par une couche de protection 13 recouvrant également
le circuit 11, cette couche de protection étant constituée par un matériau plastique présentant les propriétés d'être perforable et rétractable et ayant par exemple dans le cas d'une carte normalisée une
épaisseur de l'ordre de 0,2 mm. De tels matériaux sont par exemple des
élastomères silicones, tels que ceux fabriqués par la Société Rhône
Poulenc sous les désignations RTV 141, CAF neutres ; d'autre part, le
contact palpeur 16 de l'appareillage 15 est constitué par une tige en
métal dur se terminant par une pointe 17. Ce métal est, par exemple,
le tungstène qui présente une dureté élevée appropriée et qui permet
d'obtenir par voie électrolytique des pointes très effilées ayant un
rayon de l'ordre de 5 à 100 microns, ou encore un métal de dureté supérieure à celle du matériau du contact palpé, par exemple en acier.

Pour établir la connexion entre les éléments 10 et 15, la pointe 17
de la tige 16 peut être amenée par un mouvement de descente verticale
suivant sa direction axiale F au contact avec la borne 14 et appliquée
contre celle-ci avec une force déterminée, par exemple au moyen d'un
dispositif auxiliaire 18 tel qu'un moteur magnétoélectrique dont la
bobine mobile se déplace dans le champ annulaire d'un aimant permanent. Ce dispositif auxiliaire peut être commandé soit par un opérateur, soit, dans le cas d'une carte à transactions, automatiquement par le dispositif de transfert de données au cours d'un processus de lecture et/ou d'écriture de données dans la mémoire du circuit électronique.

Sous l'effet de cette force, le matériau de la couche 13 va d'abord fluer, puis être perforé par la pointe 17 de la tige 16. Au retrait de la pointe, le matériau tend à reprendre naturellement sa forme initiale et à se refermer sur le trou de perforation, réassurant la protection de la borne 14 vis-à-vis des agents extérieurs. La tige 16 est reliée par un fil souple à un circuit d'utilisation extérieur 19.

Le métal constituant la borne 14 est choisi avec une dureté inférieure à celle du tungstène formant la tige 16, par exemple en cuivre, argent, indium ou en métaux et alliages présentant des caractéristiques de conductibilité appropriée. La force d'application de la tige 16 sur la borne 14 est ajustée en fonction du rayon de la pointe 17 et de la nature du métal constituant la borne ; la profondeur de pénétration de la pointe dans l'ensemble des éléments 13-14, variant en fonction des considérations précédentes, détermine l'aire de contact pour une pointe 17 de rayon donné.

Le principe de cette connexion peut être appliqué aux circuits de semi-conducteurs montés sur film souple, communément appelé TAB (transport automatique sur bande), comme cela est représenté fig. 2. Dans ce cas, la carte à mémoire 20 est constitué par un support 22 en matériau isolant sur lequel est monté un circuit électronique 21 sous forme de pastille de circuit intégré rattaché par ses conducteurs 24 aux bords d'une ouverture 25 ménagée dans un film souple 26, ces conducteurs 24 ayant l'une de leurs extrémités soudée à un plot 27 de la pastille et leur autre extrémité 28 fixée à un bord de l'ouverture 25 et servant de plage de test. L'ensemble est, comme précédemment dans le cas de la fig. 1, recouvert d'une couche de protection 13 en matériau plastique perforable et rétractable. Dans ce mode de réalisation de la carte 20, la connexion avec l'appareillage 15 s'établit sur la plage de test à l'extrémité 28 de chaque conducteur 24.

Afin d'éviter toute étincelle qui risquerait de détruire la couche protectrice 13, il est dans tous les cas prévus des moyens de temporisation n'autorisant le passage du courant dans la connexion qu'après établissement effectif du contact entre la pointe 17 et la borne 14 ou l'extrémité 28 du conducteur 24. On a constaté en pratique que la résistance électrique d'une telle connexion était inférieure à 0,15 $\Omega$ sous un courant de 0,3 A.

Dans le cas où le circuit, sous la forme de réalisation de la fig. 1 ou de la fig. 2, présente plusieurs contacts alignés, l'appareillage comprend un ensemble de tiges pointues analogues à la tige 16, en nombre correspondant et assemblées pour constituer un ou plusieurs peignes dont le mouvement de descente est commandé par un organe commun.

Bien entendu, l'appareillage coopère, de façon connue, avec des moyens de transport et d'arrêt de la carte permettant d'amener et de positionner cette dernière avec précision par rapport aux contacts de palpage de l'appareillage de façon que ceux-ci soient en coincidence avec les contacts de la carte quand on leur imprime un mouvement de descente en vue d'établir leur connexion électrique.

Dans les figures précédentes, on a représenté la carte comportant le circuit électronique comme étant intégralement recouverte par la couche de protection en matériau perforable et rétractable. En fait, la présence de cette couche n'est nécessaire que dans la zone utile de palpage à l'aplomb des contacts, le reste de l'objet pouvant être recouvert par une couche de protection auxiliaire en matériau approprié quelconque, puisque n'ayant pas à subir de perforation. Il peut être encore prévu que cette couche de protection auxiliaire recouvre la couche en matériau perforable et rétractable, à condition que son épaisseur soit relativement faible à cet endroit (de l'ordre de 5 $\mu$).

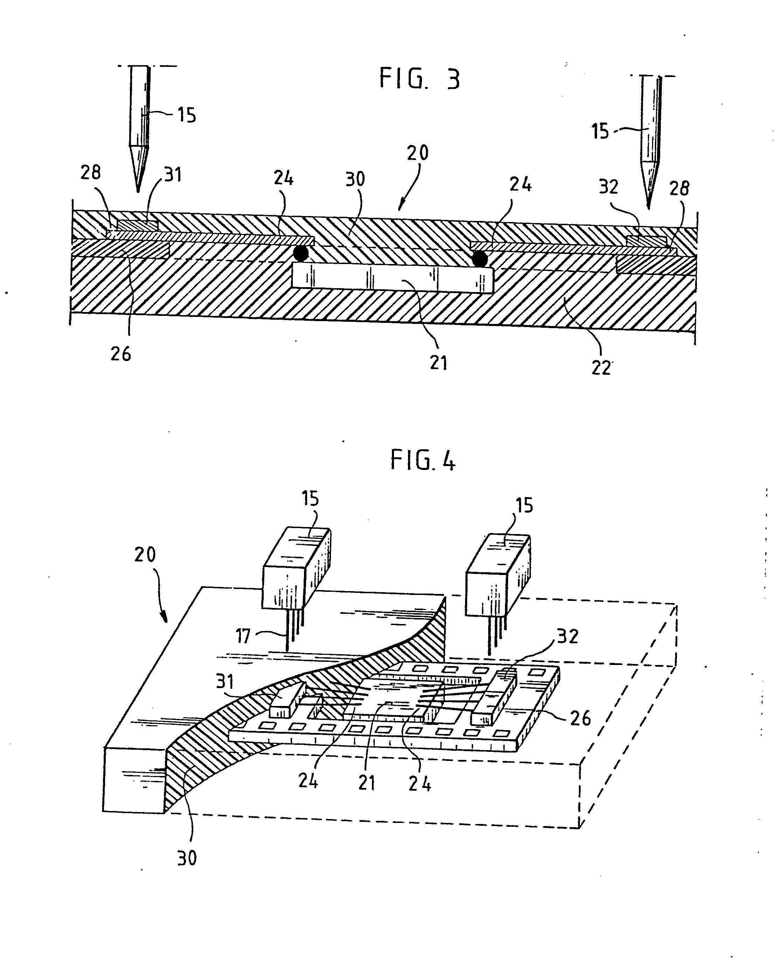

Un tel mode de réalisation est représenté aux fig. 3 et 4, qui ne diffère de celui de la fig. 2 que par l'existence de deux "fenêtres" 31 et 32 en matériau plastique perforable et rétractable disposées dans la zone recouvrant les extrémités 28 des conducteurs 24 aux endroits de palpage de ces conducteurs (au nombre de quatre, sur la fig. 4) par les pointes 17 de l'appareillage 15. Ces fenêtres 31, 32 ont par exemple des dimensions un peu supérieures à celles des peignes constituant l'ensemble de ces pointes. De plus l'ensemble de l'objet est recouvert par une couche 30 de matériau isolant, par exemple en polyester, dans laquelle sont enrobés le circuit 21 avec ses conducteurs 24, le film 26, et les fenêtres 31,32.

## REVENDICATIONS

1 - Système de connexion électrique entre une carte à mémoire ou analogue amovible, porteuse d'un circuit électronique recouvert extérieurement d'une couche de protection, et un appareillage électrique pour établir une liaison électrique entre au moins une paire de contacts respectivement disposés dans l'appareillage et dans la carte, caractérisé en ce que :

- d'une part ladite couche de protection (13) du circuit électronique (11) est constituée au moins à l'aplomb du contact (14), par un matériau plastique présentant la propriété d'être perforable,

- d'autre part, ledit appareillage (15) comporte au moins une tige en métal dur (16), se terminant par une pointe (17) pouvant être, en fonctionnement, appliquée avec une force déterminée sur le contact (14) de la carte à travers la couche de protection (13).

2 - Système suivant la revendication 1, caractérisé en ce que ledit matériau plastique présente la propriété d'être, en outre, rétractable.

3 - Système suivant la revendication 1, caractérisé en ce que ledit matériau plastique est du genre élastomère silicone.

4 - Système suivant la revendication 1, caractérisé en ce que le métal dur constituant la pointe est le tungstène.

5 - Système suivant la revendication 4, caractérisé en ce que la pointe est obtenue par voie électrolytique.

6 - Système suivant l'une des revendications précédentes, caractérisé en ce que le contact de l'objet est en métal ou alliage de dureté inférieure à celle du tungstène, de la série du cuivre, argent, indium.

7 - Système suivant la revendication 1, caractérisé en ce que la force d'application de la tige est déterminée en fonction du rayon de cette pointe et de la nature du métal constituant le contact de l'objet.

8 - Système suivant l'une des revendications précédentes, caractérisé en ce que ladite tige est mobile suivant une direction axiale.

9 - Système suivant l'une des revendications précédentes, caractérisé en ce que le rayon de la pointe en métal dur est compris entre 5 et 100 microns.

10 - Système suivant l'une des revendications précédentes, caractérisé en ce qu'il comporte des moyens de temporisation pour n'autoriser le passage du courant dans une connexion qu'après établissement des contacts respectifs de l'objet et de l'appareillage.

11 - Système suivant l'une des revendications précédentes, caractérisé en ce que ladite couche de protection en matériau perforable et rétractable est limitée à la zone utile de palpage du (ou des) contact de l'objet par la pointe de la (ou des) tige de l'appareillage.

12 - Système pour connecter une carte à mémoire avec un appareil de traitement des données contenues dans la carte, ladite carte comportant un circuit électronique muni de contacts, caractérisé en ce que, d'une part, lesdits contacts (28) sont recouverts extérieurement par une couche de protection (13 ; 31) constituée par un matériau plastique présentant la propriété d'être perforable, d'autre part ledit appareil de traitement (15) comporte des tiges en métal dur se terminant respectivement par des pointes (17) pouvant être en fonctionnement, appliquées avec une force déterminée sur les contacts du circuit de la carte à travers leur couche de protection.

13 - Système suivant la revendication 12, caractérisé en ce que ledit matériau plastique présente, en outre, la propriété d'être rétractable.

14 - Carte à mémoire, utilisable dans le système de connexion suivant la revendication 12, et comportant un circuit électronique muni de contacts, caractérisée en ce que lesdits contacts sont solidaires d'une couche de protection extérieure constituée par un matériau plastique ayant la propriété d'être perforable.

15 - Carte à mémoire suivant la revendication 14, caractérisée en ce que ledit matériau plastique présente, en outre, la propriété d' être rétractable.

16 - Carte à mémoire suivant la revendication 14 ou 15, caractérisée en ce que l'ensemble du circuit électronique, des contacts et de leur couche de protection sont enrobés dans une couche de protection auxiliaire.

FIG.1

FIG. 2

FIG. 3

FIG. 4

Numéro de la demande

EP 80 40 1671

Office européen
des brevets

**RAPPORT DE RECHERCHE EUROPEENNE**

| Catégorie | Citation du document avec indication, en cas de besoin, des parties pertinentes | Revendication concernée |
|---|---|---|
| | DE - A - 2 204 263 (VOLKSWAGENWERK A.G.)<br><br>* figures 1 à 3; pages 2 et 5 *<br><br>-- | 1,7,8 |
| | US - A - 3 804 983 (HURST)<br><br>* en entier *<br><br>-- | 1,7 |
| A | FR - A - 2 359 464 (FIRMA MAGNET-DRUCK, STEENKEN & CO.)<br><br>* figure 6; de page 2, ligne 6 à page 3, ligne 3 *<br><br>-- | 1,14 |
| A | WO - A - 79 00 543 (MORENO)<br><br>* figures 1 à 4; pages 1 à 3 *<br><br>-- | 1 |
| A | US - A - 2 817 824 (ALBRIGHT)<br><br>* figures 1,4 et 5; colonnes 1,2 *<br><br>------ | 1 |

**DOCUMENTS CONSIDERES COMME PERTINENTS**

**CLASSEMENT DE LA DEMANDE (Int. Cl.³)**

G 06 K   7/06
          19/06

**DOMAINES TECHNIQUES RECHERCHES (Int. Cl.³)**

G 06 K   7/04
         7/06
         19/06

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

Le présent rapport de recherche a été établi pour toutes les revendications

| Lieu de la recherche | Date d'achèvement de la recherche | Examinateur |
|---|---|---|
| La Haye | 04-03-1981 | PESCHEL |

OEB Form 1503.1   06.78